# EUROPÄISCHE PATENTSCHRIFT

(11) **EP 0 722 513 B1**
(45) Veröffentlichungstag und Bekanntmachung des Hinweises auf die Patenterteilung: **26.01.2000**
(21) Anmeldenummer: 94927495.5
(22) Anmeldetag: 27.09.1994
(51) Int. Cl.: C23G 5/00, B08B 7/00, A61L 2/10, A61L 2/14

(54) **OBERFLÄCHENBEHANDLUNG MIT BARRIERENENTLADUNG**
Treatment of surfaces by barrier discharge
TRAITEMENT DE SURFACES PAR UNE DECHARGE A BARRIERE DIELECTRIQUE

(30) Priorität: 27.09.1993 DE 4332866; 03.02.1994 DE 4404034
(43) Veröffentlichungstag der Anmeldung: 24.07.1996
(73) Patentinhaber: FRAUNHOFER-GESELLSCHAFT ZUR FÖRDERUNG DER ANGEWANDTEN FORSCHUNG E.V., 80636 München (DE)
(72) Erfinder: NEFF, Willi, B-4721 Kelmis (BE); LEBERT, Rainer, 4721 Kelmis (BE); POCHNER, Klaus, D-52072 Aachen (DE)
(74) Vertreter: Olgemöller, Luitgard, Dr.
(86) Internationale Anmeldenummer: DE9401132
(87) Internationale Veröffentlichungsnummer: WO9509256

(56) Entgegenhaltungen:
- EP-A- 0 254 111
- EP-A- 0 510 503
- DE-A- 4 307 768
- DE-B- 1 222 241
- DE-B- 2 014 646
- DE-C- 4 302 465
- GB-A- 829 929
- US-A- 4 446 110
- JOURNAL OF APPLIED PHYSICS, Bd.68, Nr.5, 1. September 1990, NEW YORK US Seiten 2027 - 2037 ELIASSON B. 'Investigation of resonance and excimer radiation from a dielectric barrier discharge in mixtures of mercury and the rare gases'
- JOURNAL OF VACUUM SCIENCE AND TECHNOLOGY: PART A, Bd.3, Nr.3, 1. Mai 1985, NEW YORK US Seiten 1027 - 1034 VIG J. R. 'UV/ozone cleaning of surfaces'
- J. Appl. Spectroscopy 41 (1984), Seiten 1194-1197

## Beschreibung

Die Erfindung betrifft die Verwendung einer Barrierenentladung (auch: dielektrisch behinderte Entladung oder stille Entladung genannt) für einen neuen Zweck, namentlich die Oberflächenbehandlung, insbesondere deren Reinigung wie z.B. auch Sterilisation oder Desinfektion. Sie betrifft auch ein Behandlungsverfahren, insbesondere Reinigungsverfahren, für beliebige Oberflächen, wobei entweder eine leitfähige Elektrode oder das Dielektrikum der Anordnung, die die dielektrisch behinderte Entladung bewirken kann, beweglich ist.

Oft geht es darum, Oberflächen zu reinigen, ohne diese Oberflächen in ihren chemischen oder physikalischen Eigenschaften zu verändern, und nur die auf ihr befindlichen Fette, Schmutzstoffe oder Öle (meist im wesentlichen Aliphate mit geringer Menge an Aromaten, wie Benzol, Toluol oder Xylol) zu entfernen. Dazu können Laugen und Waschmittel eingesetzt werden, die allesamt wenig umweltverträglich sind. Wenn metallische Werkstoffe, wie Walzbleche von Walzöl befreit werden sollen, wird das im Stand der Technik meist durch Glühen der auf Haspeln gewickelten Bleche in großen Öfen geschehen, die neben erheblichem Energiebedarf auch ein wenig effektives Säubern der gewalzten Metallbleche erreichen, da das Walzöl, um die gehaspelte Folie zu verlassen, zeitaufwendig durch die Wickelspalte zum Rand der Walzblechrolle diffundieren muß.

Oft geht es auch darum, Oberflächen zu sterilisieren, ohne diese Oberflächen in ihren chemischen oder physikalischen Eigenschaften zu verändern. Eine übliche Sterilisation arbeitet mit heißem Dampf und ist daher nicht bei empfindlichen Geräten oder Objekten einsetzbar. Es macht dabei keinen Unterschied, ob heißer Dampf von 180°C über einen **kurzen** oder nur etwa 100°C "warmer" Dampf über einen **längeren** Zeitraum zur Sterilisation einwirkt; beide Varianten sind gleichermaßen beanspruchend für empfindliche Sterilisate. Ersichtlich ist auch, daß höherer Druck nicht nur höhere Belastungen sondern auch höheren apparativen Aufwand mit sich bringt. Wird herkömmlich desinfiziert, so müssen meist übel riechende Reagenzien verwendet werden.

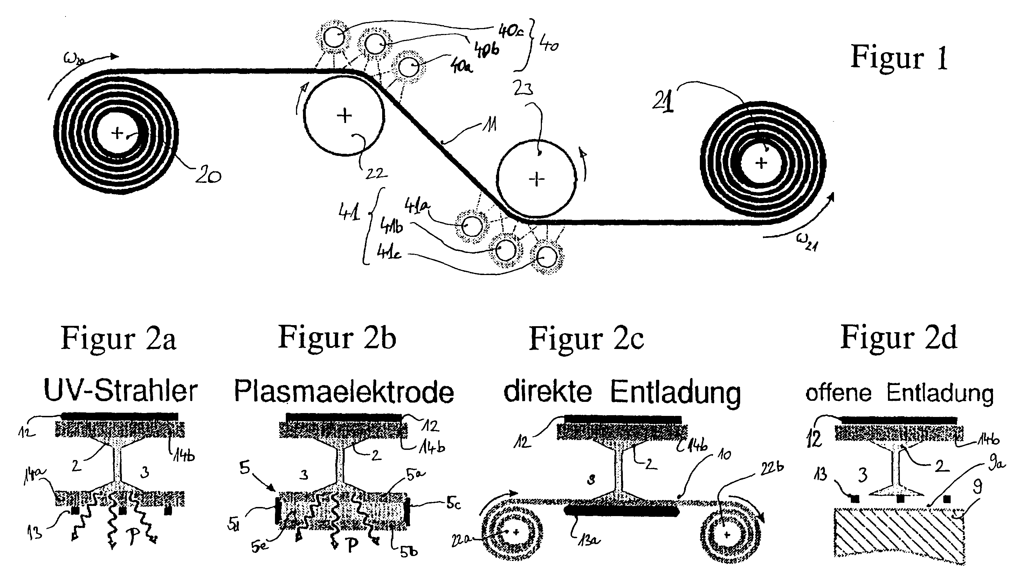

Gut bekannt zur Reinigung von Oberflächen ist die Korona-Entladung, die nicht zur Bildung einer UV-Strahlung herangezogen wird, sondern direkt auf den zu behandelnden Werkstoff auftrifft, vgl. hierzu **GB-B 829,929** (Kritchever, 1960), **DE-A 20 14 646** (Softal/Bille, 1971) und **DE-A 12 22 241** (BASF/Hambsch, 1964) sowie **US 4,446,110** (Ahlbrandt, 1984). Kritchever beschreibt die Behandlung von ölverschmutzten Metallfolien, Blechen oder Bändern, bei der diese metallischen Objekte eine Elektrode bilden, der in einem Abstand eine zweite Elektrode gegenübergestellt ist, die an den anderen Anschluß einer Spannungsquelle angeschlossen ist. Um zu verhindern, daß eine "disruptive sparking", also ein direkter Durchschlag zwischen den beiden Elektroden entsteht, wird eine den Widerstand zwischen den Elektroden erhöhende dielektrische Schicht zwischen die Elektroden gebracht, die im Abstand von der elektrisch leitenden Metallfolie (die zu reinigen ist) angeordnet ist, bevorzugt an der Elektrode 14, vgl. dort Seite 1, Zeile 59 bis 71, 83 bis 88 und 10 bis 13. Mit einer solchen Anordnung kann ein "disruptive sparking" verhindert werden und es bildet sich stattdessen eine "visible korona" or "brush discharge" zwischen den Elektroden und der Folie aus, vgl. dort Seite 2, Zeilen 5 bis 12 und Seite 3, Zeilen 83 bis 88. Mit einer vergleichbaren Verhinderung von "disruptive sparking", also der Bildung einer "visible korona" oder "brush discharge" befaßt sich Ahlbrandt; dort werden einer zylinderförmigen ersten Elektrode (dort 1) langgestreckte und in etwa viereckig im Querschnitt ausgebildete Elektrodenstäbe (dort 3,4) im Abstand gegenübergestellt. Die Elektrodenstäbe sind innen metallisch leitend und mit Quarz beschichtet, wobei jeweils eine Seitenfläche der beiden Stabelektroden tangential zu der zylinderförmigen ersten Elektrode ausgerichtet ist, aber von der Kantenlänge her übermäßig viel kleiner als der Durchmesser von der zylindrischen Gegenelektrode ist, vgl. dort Spalte 3, Zeile 59 bis Spalte 4, Zeile 5 in Verbindung mit Figur 1. Als Werkstoffe, die von dieser Vorrichtung zu behandeln sind, werden "fluffy material" oder ölbeschichtete Produkte beschrieben, vgl. dort Spalte 3, Zeile 1 bis 16. Das besondere Augenmerk dieser Vorrichtung liegt darin, eine bessere Kühlung der Elektroden zu erhalten, um zu verhindern, daß die beschriebenen Materialien an den Elektroden verbrennen, vgl. Spalte 3 a.a.O. und ebenso verhindert werden kann, daß die Quarzbeschichtung sich lokal aufheizt und ihre Isoliereigenschaft verliert, vgl. dort Spalte 1, Zeilen 20 bis 28. Der zu diesem Kühlungszweck aufgebrachte Luftstrom zwischen den eng benachbarten stab- oder stangenförmigen Elektroden sorgt für diese intensive Kühlung der Oberfläche, während sich im Betrieb bei aktiver Strömung eine Korona-Entladung zwischen den stangenförmigen Elektroden (dort 3,4) und der einen großen Durchmesser aufweisenden zylindrischen Gegenelektrode (dort 1) ausbildet, welche Korona-Entladung auch "brush-discharge" benannt wird, nach den Elektroden, die als "brush-electrodes" bezeichnet werden, also solche Elektroden, die eine "brush-discharge" im Sinne einer Korona-Entladung zur Verfügung stellen. Die Korona-Entladung entsteht besonders bei inhomogenen Feldern, die sich bei den eng beieinander liegenden Kanten der Elektrodenstäbe ausbilden und zu der starken Erwärmung besonders in diesen Bereichen führen, weshalb die Kühlung von Ahlbrandt auch benötigt und verbessert wird. Noch ohne eine solche Kühlung arbeiten die Vorschläge von Softal/Bille und BASF/Hambsch. Ersterer verwendet elektrisch leitende Trägerbahnen, insbesondere Aluminium-Folien, die einen Pol bilden und über mindestens eine umlaufende Walzenelektrode geführt werden, die mit einem dielektischen Stoff beschichtet ist; zwischen der Walzenelektrode und der Aluminium-Folie wird eine Spannung angelegt, die zur Einwirkung eines hochfrequenten Wechselfeldes, Ionenbeschuß, Elektronenbombardement und Korona-Entladung (Raumladung) führt, vgl. dort Spalte 2, Zeile 40 bis 61, wobei die elektrische Funkenentladung sogar durch den festen dielektischen Werkstoff hindurchschlägt, vgl. dort Spalte 2, Zeile 40 bis 61 und Spalte 1, Zeile 61 bis 64. Der Vorschlag von BASF/Hambsch verwendet in einer Gasatmosphäre zwischen einer isolierten Gegenelektrode und einer zu behandelnden (bewegten) Folie elektrische Entladungen, die als Büschelentladungen ("brush-discharge") erläutert werden, vgl. dort Spalte 2, Zeile 25 bis 29 und 38 bis 44 sowie die dortige Figur. Solche Korona-Entladungen führen zu hoher Erwärmung und können deshalb entweder von der Leistung her nur begrenzt eingesetzt werden oder erfordern zusätzliche intensive Kühlung, um Beschädigungen an den dielektischen Schichten zu vermeiden.

**Aufgabe** der Erfindung ist es deshalb eine Erwärmung der Oberflächen zu vermeiden, und gleichwohl eine schnelle, umweltverträgliche und gründliche Behandlung, insbesondere Reinigung, der erwähnten Oberflächen zu erhalten, die auch schonend mit den zu behandelnden Oberflächen umgeht.

Das wird dann erreicht, wenn eine direkt einwirkende dielektrisch behinderte Entladung verwendet wird (Anspruch 1), wobei sie selbst (direkt) die Oberfläche behandelt, insbesondere reinigt (Anspruch 2). Die durch sie hervorgebrachte UV-Strahlung ergänzt die Behandlung, insbesondere Reinigung (Anspruch 3) vorteilhaft.

Die Sterilisation ist ein Sonderfall eines Reinigungsverfahrens für beliebige Oberflächen (Anspruch 14).

Daß die dielektrisch behinderte Entladung (im folgenden: "dbE") die Oberflächenbehandlung ausführt, beruht auf plasmachemischer Zersetzung durch Einwirkung geladener Teilchen aus dem Entladungsraum. Auch eine Kombination aus photochemischer Zersetzung der Verunreinigungen durch die UV-Emmision der dielektrisch behinderten Entladung und plasmachemischer Zersetzung erfüllt die gründliche, mit keiner oder nur geringer Erwärmung arbeitende Behandlung.

Daneben ist auch die Einwirkung eines Reaktionsmittlers denkbar (Anspruch 6), der mittelbar oder unmittelbar an der plasmachemischen, insbesondere mit photochemischer Zersetzung beteiligt ist.

Ein Verfahren, bei dem entweder eine der leitfähigen Elektroden oder eine der dielektrischen Schichten der dielektrisch behinderten Entladungsanordnung bewegt wird, erfüllt auch die gründliche und erwärmungsarme Behandlung, insbesondere Reinigung (Anspruch 9). Je nachdem, ob der zu reinigende Werkstoff metallischer Natur ist, oder ob er isolierender Natur ist, kann er als Elektrode oder Dielektrikum in der Anordnung für die "dbE" eingesetzt werden und so gleichzeitig das bearbeitete Objekt und Bestandteil der Entladungsanordnung sein (Anspruch 10, 11).

Entweder kann ein leitfähiges Instrument (Elektrode) oder das Dielektrikum (ein Verbandsstoff oder Implantat), der die "dbE" bewirkenden Anordnung beweglich sein.

Es ist auch möglich, die gesamte Anordnung für die dielektrisch behinderte Entladung gegenüber der Oberfläche zu bewegen (oder umgekehrt), wenn Werkstück-Oberflächen behandelt, insbesondere gereinigt, werden sollen, die aufgrund ihrer geometrischen Form oder Konsistenz nicht innerer Bestandteil der erwähnten Entladungsanordnung sein können, sondern nur als Entladungsraumbegrenzung eingesetzt sind (Anspruch 12). Dabei wird eine Netzelektrode verwendet, die sich in unmittelbarer Nähe der Oberfläche befindet. Es bildet sich auf diese Weise eine offene Entladung aus.

Im Stand der Technik wird die Erzeugung von Barrierenentladungen näher erläutert, vgl. **Journal of Applied Spectroscopy (JAS),** Band 41, Nr. 4, Oktober 1984, Seiten 1194 bis 1197. Die **EP-B 254 111** (ABB), in der sich eine Mehrzahl von Ausführungsbeispielen befinden zeigt Hochleistungs-UV-Erzeuger, die in ihrem Innern eine "dbE" realisieren. Noch detaillierter wird die "dbE" in **Journal of Applied Physics (JAP),** Band 68, Nr. 5, 1. September 1990, N.Y., Seiten 2027 bis 2037 beschrieben, speziell Seite 2026 linke und rechte Spalte sowie 2027, erster Absatz mit dem zugehörigen Bild der dortigen Figur 1. Die dort als Barrierenentladung oder stille Entladung benannte "dbE" wird als eine Hochdruck-Wechselspannungs-Entladung beschrieben, die in einem Spalt entsteht, in dem eine oder beide der Elektroden mit einem Dielektrikum bedeckt sind. Wenn die Spannung oberhalb der Paschen- oder Durchbruchsspannung des Spaltes ist, fließt ein Strom durch den Spalt, der von einer Anzahl von Ladungsfilamenten oder Mikroentladungen getragen wird, die statistisch über die Zeit und im Raum gemäß der dortigen Figur 1 verteilt sind. Aufgrund eines Ladungsaufbaus auf dem Dielektrikum, der durch den Stromfluß entsteht, wird ein Feld mit entgegengesetztem Vorzeichen in dem Filament gebildet und so senkt sich die Feldstärke und die Ionisation nimmt ab. Dadurch fällt der Strom durch das Entladungsfilament auf Null und bildet so einen kurzen Impuls in der Größenordnung einiger ns bis einigen 100 ns, abhängig vom Gas und von der Entladungskonfiguration, die verwendet wurde. Eine statistische Verteilung der beschriebenen Entladungsfilamente und ihre kurze Dauer verhindert eine Aufheizung der Gasmoleküle und diese dielektrische Entladung wird in dieser Art schon lange verwendet, um Ozon in großen Mengen zu erzeugen. In der genannten JAP-Schrift wird diese Ladung als Plasmareaktor verwendet und ein Lampenaufbau untersucht, bei dem eine Strahlung aus einer Mischung aus Quecksilber und einem seltenen Gas (dort Xenon) entsteht, untersucht; unter Ziffer III (Seite 2029) werden UV-Quellen mit verschiedener Geometrie als Anwendungsmöglichkeiten für die beschriebene Barrierenentladungen erläutert, wobei aber eine oder beide Elektroden für die erzeugte Strahlung durchlässig (also transparent) sein muß. Die beschriebenen UV- und VUV-Quellen werden als besonders für die "photo assisted chemical vapor deposition" geeignet beschrieben, vgl. dort Ziffer VI, Seite 2037, letzter Absatz.

Darüber, daß die "dbE" selbst zu Oberflächen-Behandlungszwecken oder zur Sterilisation eingesetzt werden kann, ist den erwähnten Fundstellen des Standes der Technik nichts zu entnehmen.

Die Erfindung (Ansprüche 1, 9, 12) verwendet eine "dbE" direkt für die Oberflächenbehandlung und gibt technische Ausgestaltungen an, wie eine offene oder direkte Entladung realisiert werden kann (Anspruch 7, 8; Anspruch 10, 11).

Werden Metalloberflächen gereinigt, die unmittelbar nach ihrer Herstellung von einem Ölfilm bedeckt sind, der vor der Weiterverarbeitung zum Beschichten oder Verkleben entfernt werden muß, so kann die Erfindung den Ölfilm durch Einwirkung hochenergetisch geladener Teilchen und durch Photonen aus dem ultravioletten Spektralbereich so beseitigen, daß er bereits nach kurzer Zeit so weit entfernt ist, daß eine Benetzung der Metalloberfläche mit Wasser, mit einem Beschichtungsstoff oder mit einem Klebstoff möglich ist. Die Erfindung schafft es bei einer beispielsweisen Einwirkungsdauer von nur wenigen Sekunden, eine Zielvorgabe von Öl- oder Fettbelägen unter 4 mg/m² zu erreichen. Werden Aluminiumfolien im Lebensmittelbereich, beispielsweise für Tiefziehbehälter oder für heißsiegelbare Foliendeckel verwendet, so muß der erwähnte beispielsweise Rest- Fett- bzw. -Ölbelag um eine weitere Zehnerpotenz reduziert werden.

Zur Verbesserung der Benetzbarkeit für nachfolgende Prozeßschritte wird die Verunreinigung durch photochemische oder plasmachemische Einwirkung in ihrer Zusammensetzung verändert.

Längere Kettenmoleküle in Fetten und Ölen können dabei aufgebrochen werden und als flüchtige Reaktionsprodukte die Oberfläche verlassen. Ebenso ist es möglich, sie zu Stoffen umzuwandeln, die bei einer Weiterverarbeitung nicht stören. Auch können sie in ihrer Konsistenz so verändert werden, daß sie keinen geschlossenen Film mehr bilden.

Neben der schnellen, gründlichen und energiearmen, weil nicht erwärmenden, Reinigung ist die erfindungsgemäße Lösung auch besonders umweltfreundlich, da keine Laugen oder sonstigen umweltbelastenden Chemikalien eingesetzt werden müssen.

Unmittelbare Folge der energiearmen und erwärmungslosen (erwärmungsarmen) Reinigung der Metall-Folie ist **die schonende Behandlung der Oberfläche**, die ohne Rekristallisation oder Beeinflussung der walzharten Struktur völlig intakt bleibt.

Auch in der Handhabung ist die Erfindung erfreulich unkompliziert und paßt sich in ihren Gestaltungen an eine Vielzahl von Reinigungsaufgaben leicht an.

Kann der zu reinigende Werkstoff in einem kontinuierlichen Prozeß als Bestandteil der Entladungsvorrichtung durch sie hindurch oder an ihr vorbeigezogen werden, so kann auch ein Verschleiß der Bearbeitungsanordnung (der Entladungsanordnung) günstig vermieden werden. Das heißt, daß bei Verwendung eines beispielsweise metallischen Werkstoffbandes als eine der Elektroden, diese als feststehende Elektrode entfällt, die ansonsten regelmäßig nach längerem Gebrauch infolge Elektrodenabbrand ausgetauscht werden müßte.

Der immer neu in die Entladungsanordnung eintretende oberflächenverschmutzte Werkstoff wird in der Entladungsanordnung als ihr Bestandteil sorgfältig, energierarm und schonend gereinigt, um die Entladungsanordnung dann oberflächengereinigt zu verlassen.

Besteht die Oberfläche des zu behandelnden Werkstückes aus einem Kunststoff, so kann neben oder anstelle einer Reinigung auch eine Modifikation der Kunststoffoberfläche erfolgen. Durch plasma- oder photochemische Veränderung der Moleküle im Kunststoff wird eine Aktivierung der Oberfläche ausgelöst. Dabei können z.B. freie Bindungen an der Oberfläche erzeugt werden oder eine mikroskopische Strukturänderung durchgeführt werden (Anspruch 13).

Bei Verwendung eines isolierenden Werkstoffbandes kann eine oder eine der mehreren dielektrischen Barrieren vor den Elektroden entfallen, so daß ein Verschleiß dieser Barriere durch Sputtereffekte oder Ionenimplantation ausgeschlossen werden kann.

Einige Ausführungs**beispiele** sollen das Verständnis der Erfindung vertiefen.
**Figur 1** zeigt ein Beispiel einer metallischen Aluminiumfolie, die von einer Abwickelhaspel 20 über Umlenkwalzen 22, 23 auf eine Aufwickelhaspel 21 geführt wird.
**Figur 2a, 2b**, **2c** und **2d** zeigen vier Ausgestaltungen einer Entladungsanordnung, die eine dielektrisch behinderte Entladung bei Anlegen einer hochfrequenten Hochspannung bewirkt, und deren Entladungsergebnis auf verschiedene Weisen beeinflußt wird und in verschiedenen Anwendungszwecken zur Reinigung von Oberflächen verwendet wird.

Die metallische Aluminiumfolie 11 verläßt die Aufwickelhaspel 20 in **Figur 1** und wird über die beabstandeten gegensinnig drehenden Umlenkhaspeln 22, 23 geführt, bevor die Folie 11 auf der Aufwickelhaspel 21 wieder aufgewickelt wird. Dort liegt sie in gereinigter Form vor, weil sie beidseitig zwischen Abwickeln und Aufwickeln von Barrierenentladungen gereinigt wurde. Die Barrierenentladungs-Vorrichtung 40a, 40b und 40c bzw. 41a, 41b und 41c, die der Umlenkwalze 22 bzw. der Umlenkwalze 23 zugeordnet sind, werden unten - mit Geltung für alle Beispiele - näher erläutert.

In allen beschriebenen Beispielen erzeugen die Barrierenentladungen kurzzeitige Entladungsfilamente 2, wenn die beiden Elektroden, zwischen denen sich mindestens ein Dielektrikum befinden muß, mit einer Hochspannung von typisch 5kv und etwa 100kHz bis 200kHz beaufschlagt werden. Anstelle der Hochfrequenz kann in einer preiswerten Vorrichtung zur Erzeugung einer dbE auch eine niedrige Frequenz, beispielsweise 50Hz oder 60Hz eingesetzt werden. Eines dieser Entladungsfilamente existiert jeweils nur für wenige Nanosekunden und besitzt einen Durchmesser in der Größenordnung von 100µm. Während der Entladung bildet sich auf dem elektrisch isolierenden Dielektrikum zwischen den metallischen Elektroden innerhalb eines Fußpunktes eine Oberflächenladung aus, die einen Durchmesser von zwischen 0.5cm und 5cm haben kann. Durch sie wird die Entladung an dieser Stelle unterbunden. Erst bei weiterem Spannungsanstieg der erwähnten hochfrequenten Hochspannung bzw. nach Spannungsumkehr kann eine weitere dieser Mikroentladungen an derselben Stelle erfolgen.

Mittels dieser Mikroentladungen können die Oberflächen schonend gereinigt werden. Die Oberflächen können aber auch durch die von den Mikroentladungen ausgelöste UV-Strahlung gereinigt werden. Auch eine Mischung aus beiden Reinigungsprozessen - der photochemischen Zersetzung (durch energiereiche Photonen) oder der plasmachemischen Zersetzung (durch Einwirkung geladener Teilchen) - ist möglich. Das hängt von der metallischen oder nichtmetallischen Natur des zu reinigenden Werkstoffes ab, das hängt aber auch von dessen Größe und geometrischer Gestalt ab.

Im Beispiel der **Figur 1** ist der zu reinigende Werkstoff eine Metallfolie (Dickenbereich etwa 10-100µm), es könnte ebensogut ein gewalztes Metallblech (Dickenbereich von einigen mm) sein.

Die metallische Folie 11 wird nun beidseitig von den Barrierenentladungen 40a, 40b und 40c sowie 41a, 41b und 41c gereinigt. Aufgrund der Versetzung der Umlenkwalzen 22 und 23 und der Anbringung der jeweils beispielhaften 3 Barrierenentladungen auf gegenüberliegenden Umfangsabschnitten der erwähnten Umlenkwalzen 22, 23 ergibt sich eine raumsparende und effektive Reinigungseinrichtung. Abhängig von der Anzahl der in einem Umfangsbereich konzentrisch zu der Achse den Walzen 22, 23 angeordneten Barrierenentladungen kann die Geschwindigkeit der Folie im abgewickelten Zwischenbereich verändert werden. Werden eine Vielzahl von Barrierenentladungs-Vorrichtungen umfänglich um die Walzen angeordnet oder weitere davon entlang der geraden Abschnitte der Aluminiumfolie vorgesehen, so kann die Geschwindigkeit erhöht werden. Auch eine Leistungsregelung der Barrierenentladungen ist möglich, abhängig vom Folienwerkstoff. Die Leistungsregelung wird durch eine Steuerung der Anzahl der kurzzeitigen Entladungen in den Filamenten pro Zeiteinheit erreicht; sie ist durch Variation der Frequenz, der Spannung oder durch Aussteuerung von Spannungspulsen sowie über Höhe, Form und Anstiegszeit der nicht notwendigerweise sinusförmigen Spannung möglich. Diese nicht sinusförmigen Spannungen können anharmonische Spannungen sein, wie **in DE-A 43 07 768** beschrieben, auf die Bezug genommen wird. Zu den physikalischen Grundlagen des Entstehens der dielektrisch behinderten Entladung und zur Erzeugung von UV-Strahlung wird auf "Journal of Applied Spectroscopy", Bd.41, Nr.4, Oktober 1984, Seiten 1194 bis 1197, Bezug genommen.

Der gepunktete konzentrische Ringbereich um die langgestreckten zylindrischen Mittenelektroden der Barrierenentladungens-Vorrichtungen 40 und 41 in **Figur 1** kann der Entladungsraum von Excimer-Strahlern sein, wobei die dazu ebenfalls konzentrische äußere Elektrode lichtdurchlässig ist. In diesem Fall wird die Oberfläche der Aluminiumfolie 11 durch UV-Strahlung gereinigt. Die Metallfolie 11 kann aber auch in eine Anordnung zur dbE einbezogen werden, wenn sie die Gegenelektrode bildet und über die andere Elektrode eine dielektrische Barriere (gepunkteter Bereich) gelegt wird, um mit einem dazwischenliegenden Entladungsraum die Entladungsanordnung zu komplettieren.

Wird in einem nicht dargestellten Beispiel das metallische Band 11 der Figur 1 durch eine nichtleitende Kunststoff-Folie ersetzt, so können die Umlenkwalzen 22, 23 metallisch ausgebildet werden und als Gegenelektrode fungieren. Die nichtleitende (Kunststoff-) Folie bildet dann ein Dielektrikum und wird innerhalb des Entladungsraumes hindurchgezogen.

Vier weitere Beispiele zeigen die **Figuren 2a, 2b ,2c und 2d**.

Die drei ersten Beispiele zeigen Entladungsanordnungen mit zwei Dielektrika 14a, 14b. Jeweils eines dieser Dielektrika kann entfallen, wie in Figur 2d gezeigt. Obenliegend ist in allen Beispielen eine Erstelektrode 12, der eine metallische netzförmige Gegenelektrode 13 (in Figur 2a) bzw. eine Plasmaelektrode 5 (in Figur 2b), eine plane Gegenelektrode 13a (in Figur 2c) oder dieselbe netzförmige Elektrode 13 innerhalb des Entladungsraumes 3 (wie in Figur 2d veranschaulicht) beabstandet gegenübersteht. Zwischen den beiden Elektroden 12, 13, bzw. 12, 5 bzw. 12 und 13a werden Entladungsfilamente 2 entstehen, wenn an die Elektroden hochfrequente Hochspannung angelegt wird. Die Entladungsfilamente werden allerdings erst an der inneren Oberfläche der jeweiligen dielektrischen Barriere im Entladungsraum 3 beginnen.

In **Figur 2a** ist das untere Dielektrikum 14a lichtdurchlässig, was durch die symbolisch wellenförmig eingezeichneten durchgehenden Photonen P angedeutet wird. Nachdem die Gegenelektrode 13 gitterförmig ausgebildet ist, entstehen nur geringe Abschirm-Verluste bei der Auskopplung der UV-Strahlung. Sie können mit großem Wirkungsgrad auf der zu reinigenden Oberfläche zur Einwirkung gebracht werden.

In **Figur 2b** besteht die Gegenelektrode aus einer die Filamententladung 2 im Entladungsraum 3 vergleichmäßigenden (homogenisierenden) Plasmaelektrode 5. Sie ist **in DE-A 43 02 465** näher erläutert, auf die ergänzend Bezug genommen wird. Das das Elektrodenplasma bildende Gas 5e grenzt an das eine Dielektrikum 5a an, das seinerseits den Entladungsraum 3 unten begrenzt. Die zweite Gehäusewand des das Plasma 5e enthaltenden Behälters 5 liegt gegenüber dem erwähnten Dielektrikum 5a beabstandet und ist mit 5b bezeichnet. An einer oder mehreren Schmalseiten der beabstandeten Deckplatte und Bodenplatte 5a und 5b sind metallische Elektroden 5d und 5c angeordnet, die das Elektrodenplasma 5e zu einer diffusen Niederdruckentladung anregen. Dann kann die Hauptentladung im Entladungsraum 3 durch Reduzierung der Fläche der Fußpunkte der Filamente 2 homogenisiert werden. Im übrigen und zur genaueren Darstellung des als Gegenelektrode verwendeten Plasmagehäuses 5 wird auf die **DE-A 43 02 465** verwiesen. Zu erwähnen bleibt noch, daß die beiden beabstandeten dielektrischen Platten 5a und 5b ebenfalls lichtdurchlässig sind, um der homogenisierten und in ihrer Ausbeute vergrößerten Strahlung einen Gegenelektroden-Durchtritt mit geringer Absorption zu ermöglichen.

Die **Figur 2c** zeigt eine direkte Einwirkung der dbE mit ihren Entladungsfilamenten 2 auf eine Isolierfolie oder ein Isolierband 10. Letzteres wird von einer Haspel 22a abgewickelt und von einer Gegenhaspel 22b aufgewickelt. Dazwischen durchläuft es einen Entladungsraum 3, der zwischen den erwähnten metallischen Elektroden 12 und 13a gebildet wird. Der nichtmetallische Isolator 10 (die Isolierfolie) ist damit Bestandteil der Entladungsanordnung gemäß Figur 2c und wird dabei gleichzeitig durch die kurzzeitigen Entladungen 2 mit hoher Elektronenenergie, geringer Erwärmung und guter Reproduzierbarkeit beim Durchlaufen gereinigt. Diese Reinigung kann neben der photochemischen Zersetzung, wie in den Beispielen von Figur 2a und 2b, auch einen plasmachemischen Anteil besitzen.

Nachdem die Entladungsfilamente 2 aber nur an einer Oberfläche der isolierenden und als Dielektrikum wirkenden Folie 10 angreifen, bleibt die zweite Oberfläche zunächst ungereinigt. Es empfiehlt sich daher die Hintereinanderschaltung von zwei Entladungsanordnungen, die gegensinnig so arbeiten, daß die eine Entladungsanordnung (die dargestellte) die obere Oberfläche des Folienbandes 10 reinigt, während eine ihr gegenüber um 180° (nach unten) geschwenkte zweite Entladungsanordnung die Rückseite des Folienbandes reinigt. Die beiden dann nur durch die Dicke der Folie 10 beabstandeten eng benachbarten Elektroden 13a können dabei zur Vermeidung von ungewollten Durchschlägen auf demselbem Potential liegen.

In einem Experiment ist eine mit Walzöl verunreinigte Aluminiumfolie ohne Zwischenbehandlung für einige Sekunden einer dielektrisch behinderten Entladung 40 ausgesetzt worden, und zwar in einer Anordnung, die derjenigen von **Figur 1** entspricht, wobei die Barrierenentladungs-Vorrichtungen 41 (auf der Rückseite der Folie) abgeschaltet waren. Während bei einem anschließenden Benetzungsversuch mit Wasser auf der unbehandelten Seite der Folie 11 ein sofortiges Tröpfchenbilden des Wassers stattfand, blieb auf der behandelten Seite der Folie 11 bis zur Verdunstung ein geschlossener Wasserfilm stehen.

Daraus kann auf eine weitgehende Entfernung des Walzöles geschlossen werden.

Eine Gitter-Elektrode 13 ist in **Figur 2d** gezeigt, sie bildet die Gegenelektrode zur oberen Flächenelektrode 12 und erlaubt eine nach unten offene dbE um hinsichtlich der Abmessung und Geometrie des Werkstücks 9, dessen Oberfläche gereinigt werden soll, nicht beschränkt zu sein. Das ist mit dem Isolator-Werkstück 9 veranschaulicht, das unterhalb der Gitter-Elektrode 13 angeordnet ist und von UV-Strahlung und/oder Elektronen an seiner Oberfläche gereinigt wird. Photochemische und plasmachemische Zersetzung der Schmutzstoffe auf der Werkstück-Oberfläche 9a können kombiniert werden.

Die **Figur 2d** ist ein Beispiel dafür, daß die Oberfläche eines Werkstücks beliebiger geometrischer Form gereinigt werden kann, selbstverständlich verhindert dabei die erhebliche Größe - oder: Dicke - des Werkstücks 9, daß dieses innerer Bestandteil der Entladungsanordnung selbst wird, die im Beispiel der Figur 2d aus oberer Elektrode 12 aus Gitter-Gegenelektrode 13 und einem flächigen Isolator 14b, unmittelbar angrenzend an die erwähnte Flächenelektrode 12, besteht. Die Entladungsfilamente 2 bilden sich zwischen der Oberfläche des oberen Isolators und der Gitter-Elektrode 13 im Entladungsraum 3 aus. Der Durchtritt von schnellen Elektronen und von UV-Licht durch die Gitter-Elektrode 13 ermöglicht in einem schmalen Bereich außerhalb des eigentlichen (inneren) Entladungsraumes 3 die Oberflächenreinigung. Der (innere) Entladungsraum 3 ist also gegenüber den Figuren 2a, 2b und 2c nach unten vergrößert (äußerer Entladungsraum) und wird begrenzt durch die zu reinigende Oberfläche des Werkstücks 9. Damit aber ist der tatsächliche Entladungsraum nicht vor der Gitter-Elektrode 13 beendet, sondern erst an der Oberfläche des Werkstücks 9, weshalb das Werkstück 9 mit seiner entladungsraum-begrenzenden Oberfläche 9a noch als "Bestandteil" der Entladungs-Anordnung angesehen wird, wie dies deutlicher auch an den Figuren 2a, 2b und 2c sowie der Figur 1 ersichtlich ist.

Nicht dargestellt in allen Figuren ist die seitliche Begrenzung des Entladungsraumes 3, die den Gegebenheiten angepaßt werden kann und bei einem anzustrebenden etwa atmosphärischen Druck in der Entladungskammer 3 auch nicht schwierig an den Grenzen zu dem bewegten, zu reinigenden Werkstück oder Folie oder Band zu bewerkstelligen ist. Wird die dbE in Luft unter Atmosphärendruck betrieben, können seitliche Begrenzungen entfallen. Die kontinuierliche Durchführung eines Werkstücks, einer Folie oder eines Blechs wird besonderes einfach. Alternativ können bei etwa Atmosphärendruck auch berührungslose gasdynamische Fenster als seitliche Begrenzungen angewendet werden.

Schließlich soll ein nicht dargestelltes Beispiel noch Erwähnung finden, wenn mit Kunststoff beschichtete Metallfolien an ihrer Oberfläche gereinigt werden. Diese kunststoff- oder folienkaschierten Metallfolien können dann bereits zwei Elemente der Anordnung für die dbE enthalten, namentlich den Isolator und die eine der beiden Elektroden.

Die Figur 1, die Figur 2c und die Figur 2d zeigen also drei auf einen jeweiligen konkreten Anwendungsfall abgestimmte Möglichkeiten, wie die zur reinigende Oberfläche, respektive der sie tragende Werkstoff, Bestandteil der Entladungsanordnung sein kann und gleichwohl gereinigt werden kann. Das vorerwähnte nicht dargestellte Beispiel der folienbeschichteten Metalle oder Metallfolien unterfällt ebenfalls dieser Kategorie der kompakten und verschleißarmen Entladungsanordnung mit Reinigungswirkung.

Nicht dargestellt ist auch die Desinfektion oder Sterilisation von Verbandsstoffen, Implantaten oder chirurgischen Instrumenten. Sie wird - als Spezialfall der Reinigung - mit einer der beschriebenen Entladungsstrukturen erreicht. Besonders für Verbandsstoffe eignet sich der Aufbau von **Figur 1**, wenn die Gegenelektroden die Walzen 22, 23 sind und Verbandsstoff 11 durch die Anordnung gezogen wird.

## Patentansprüche

1. **Verwendung** einer dielektrisch behinderten Entladung (2,P) für die Oberflächenbehandlung, bei der die Entladung (2,P) direkt auf die Oberfläche (10,11) einwirkt.

2. Verwendung nach Anspruch 1, bei der die Behandlung eine Reinigung ist.

3. Verwendung nach Anspruch 1 oder 2, bei der die durch die Entladung erzeugte UV-Strahlung (P) auf die Oberfläche einwirkt.

4. Verwendung nach einem der vorigen Ansprüche für Folienoberflächen (10).

5. Verwendung nach einem der Ansprüche 1 bis 3 für gewalzte Metallbleche oder Metallfolien (11).

6. Verwendung nach einem der vorhergehenden Ansprüche unter Beteiligung eines Reaktionsmittlers, wie Sauerstoff oder Ozon.

7. Verwendung nach einem der vorhergehenden Ansprüche, bei der die dielektrisch behinderte Entladung (2,P) - von außerhalb eines Entladungsraumes (3) - mittels einer Plasmaelektrode (5; 5a bis 5e) homogenisiert wird.

8. Verwendung nach einem der vorhergehenden Ansprüche, bei der die dielektrisch behinderte Entladung von einer anharmonischen Spannung veranlaßt wird.

9. **Behandlungsverfahren** für Oberflächen, bei dem eine durch eine dielektrische Schicht (10) behinderte Entladung (2) zwischen zwei leitfähigen Elektroden (13,13a;12,11) aufrechterhalten wird, während die dielektrische Schicht (10) oder mindestens eine (11) der Elektroden (13,13a;12,11) bewegt werden.

10. Verfahren nach Anspruch 9, bei dem mindestens eine der leitfähigen Elektroden (11) gereinigt und bewegt wird.

11. Verfahren nach Anspruch 9, bei dem der als Dielektrikum (10) wirkende isolierende Werkstoff, insbesondere ein Folienwerkstoff oder eine Folie (10), gereinigt und bewegt wird.

12. **Behandlungsverfahren** für Oberflächen von Isolierkörpern (9), bei dem eine Oberfläche (9a) des Isolierkörpers eine Entladungsraumbegrenzung eines Entladungsraums (3) für eine darin aufrechterhaltene dielektrisch behinderte Entladung (dbE) bildet und in unmittelbarer Nähe der Oberfläche (9a) eine Netzelektrode (13) als eine von zwei metallischen Elektroden (13,12) angeordnet ist.

13. Behandlungsverfahren nach Anspruch 9 bis 12, bei dem die Isolierkörperoberfläche modifiziert wird, insbesondere in ihrer mikroskopischen Struktur verändert wird.

14. Behandlung nach einem der vorhergehenden Ansprüche, bei der die Behandlung eine Reinigung, Sterilisation oder Desinfektion ist.

15. Behandlung nach Anspruch 14, bei der der isolierende Werkstoff ein textiles Material, wie Verbandsstoff, oder ein Implantat ist.

16. Verwendung nach Anspruch 1, bei der die dielektrisch behinderte Entladung (2) einen relativ breiten Entladungsraum (3) zwischen zwei insbesondere flächigen Elektroden (13,13a;12,11) über sein ganzes Volumen gleichförmig mit feinen Entladungs-Filamenten ausfüllt.

17. Verwendung nach Anspruch 1 oder 16, bei der die dielektrisch behinderte Entladung (2) aus kurzeitigen, insbesondere nur für wenige Nanosekunden existierenden und einen Durchmesser in der Größenordnung von 100 µm besitzenden, stromführenden Entladungsfilamenten (2) besteht, die jeweils nach Beginn ihrer Ausbildung zwischen einer Elektrode (13,13a) und einem davon beabstandeten Dielektrikum (14b) durch Aufbau einer Oberflächenladung an ihrem Fußpunkt auf dem Dielektrikum (14b) selbst verlöschen.

18. Verwendung nach Anspruch 17, bei dem die Oberflächenladung auf dem Dielektrikum (14b) lokal begrenzt ist und ein weiteres Entladungsfilament an der Stelle des gerade verloschenen Entladungsfilamentes (2) verhindert wird, bis zum Abbau der lokal begrenzten Oberflächenladung.

## Claims

1. Use of a dielectric barrier discharge (2, P) for surface treatment, in which the discharge (2, P) acts directly on the surface (10, 11).

2. Use according to claim 1, in which the treatment is cleaning.

3. Use according to claim 1 or 2, in which the UV radiation (P) produced by the discharge acts on the surface.

4. Use according to one of the above claims for foil surfaces (10).

5. Use according to one of claims 1 to 3 for rolled metal sheets or metal foils (11).

6. Use according to one of the preceding claims with participation of a reaction medium, such as oxygen or ozone.

7. Use according to one of the preceding claims, in which the dielectric barrier discharge (2, P) is homogenised by means of a plasma electrode (5; 5a to 5e) - from outside a discharge chamber (3).

8. Use according to one of the preceding claims, in which the dielectric barrier discharge is effected by inharmonic voltage.

9. Treatment process for surfaces, in which a discharge (2) blocked by a dielectric layer (10) is maintained between two conductive electrodes (13, 13a; 12, 11), while the dielectric layer (10) or at least one (11) of the electrodes (13, 13a; 12, 11) are moved.

10. Process according to claim 9, in which at least one of the conductive electrodes (11) is cleaned and moved.

11. Process according to claim 9, in which the insulating material acting as dielectric (10), in particular a foil material or a foil (10), is cleaned and moved.

12. Treatment process for surfaces of insulating bodies (9), in which a surface (9a) of the insulating body forms a discharge chamber limit for a discharge chamber (3) for dielectric barrier discharge (dbE) maintained therein, and a wire-gauze electrode (13) as one of two metallic electrodes (13, 12) is arranged in the immediate vicinity of the surface (9a).

13. Treatment process according to claim 9 to 12, in which the insulating body surface is modified, in particular is changed as regards its microscopic structure.

14. Treatment according to one of the preceding claims, in which the treatment is cleaning, sterilisation or disinfection.

15. Treatment according to claim 14, in which the insulating material is a textile material, such as bandaging material, or an implant.

16. Use according to claim 1, in which the dielectric barrier discharge (2) uniformly fills a relatively wide discharge chamber (3) between two particularly two-dimensional electrodes (13, 13a; 12, 11) with fine discharge filaments over its entire volume.

17. Use according to claim 1 or 16, in which the dielectric barrier discharge (2) consists of current-bearing discharge filaments (2) existing briefly, in particular only for a few nanoseconds, and having a diameter in the order of magnitude of 100 µm, which quench themselves in each case after the start of their formation between an electrode (13, 13a) and a dielectric (14b) at a distance therefrom by forming a surface charge at their base on the dielectric (14b).

18. Use according to claim 17, in which the surface charge on the dielectric (14b) is restricted locally and a further discharge filament is prevented at the position of the discharge filament (2) just quenched, until locally restricted surface charge is removed.

## Revendications

1. Utilisation d'une décharge (2, P) barrière diélectrique pour le traitement de surfaces, dans laquelle la décharge (2, P) agit directement sur la surface (10, 11).

2. Utilisation selon la revendication 1, dans laquelle le traitement est un nettoyage.

3. Utilisation selon la revendication 1 ou 2, dans laquelle le rayonnement ultraviolet (P) produit par la décharge agit sur la surface.

4. Utilisation selon l'une des revendications précédentes, destinée à des surfaces de feuilles (10).

5. Utilisation selon l'une des revendications 1 à 3, destinée à des tôles métalliques ou à des feuilles métalliques (11) laminées.

6. Utilisation selon l'une des revendications précédentes, avec participation d'un milieu de réaction, tel que l'oxygène ou l'ozone.

7. Utilisation selon l'une des revendications précédentes, dans laquelle la décharge barrière diélectrique (2, P) est homogénéisée - depuis l'extérieur d'un espace de décharge (3) - à l'aide d'une électrode plasma (5 ; 5a à 5e).

8. Utilisation selon l'une des revendications précédentes, dans laquelle la décharge barrière diélectrique est provoquée par une tension anharmonique.

9. Procédé de traitement pour surfaces, dans lequel une décharge (2), limitée par une couche diélectrique (10), est maintenue entre deux électrodes conductrices (13, 13a ; 12, 11), tandis que la couche diélectrique (10) ou au moins l'une (11) des électrodes (13, 13a ; 12, 11) est déplacée.

10. Procédé selon la revendication 9, dans lequel au moins l'une (11) des électrodes conductrices est nettoyée et déplacée.

11. Procédé selon la revendication 9, dans lequel la matière isolante faisant fonction de diélectrique (10), notamment une matière pour feuille ou une feuille (10), est nettoyée et déplacée.

12. Procédé de traitement pour des surfaces de corps isolants (9), dans lequel une surface (9a) du corps isolant constitue une délimitation d'espace de décharge d'un espace de décharge (3) pour une décharge barrière diélectrique (dbE) qui y est maintenue, une électrode réticulaire (13), en tant que l'une de deux électrodes métalliques (13, 12) étant disposée à proximité immédiate de la surface (9a).

13. Procédé de traitement selon les revendications 9 à 12, dans lequel la surface du corps isolant est modifiée, et plus particulièrement sa structure microscopique subit des modifications.

14. Traitement selon l'une des revendications précédentes, dans lequel le traitement est un nettoyage, une stérilisation ou une désinfection.

15. Traitement selon la revendication 14, dans lequel la matière isolante est une matière textile, telle qu'une matière à pansement, ou un implant.

16. Utilisation selon la revendication 1, dans laquelle la décharge barrière diélectrique (2) remplit en totalité un espace de décharge (3) relativement large entre deux électrodes notamment en nappe (13, 13a ; 12, 11) de manière uniforme par de fins filaments de décharge.

17. Utilisation selon la revendication 1 ou 16, dans laquelle la décharge barrière diélectrique (2) consiste en des filaments de décharge (2) conducteurs de courant, de courte durée, n'existant notamment que pendant quelques nanosecondes et ayant un diamètre de l'ordre de 100 µm, et qui, chaque fois après le commencement de leur formation entre une électrode (13, 13a) et un diélectrique (14b) situé à distance de celle-ci, s'éteignent automatiquement par la constitution d'une charge superficielle au niveau de leur base sur le diélectrique (14b).

18. Utilisation selon la revendication 17, dans laquelle la charge superficielle est localement limitée sur le diélectrique (14b) et l'apparition d'un autre filament de décharge, à la place du filament de décharge (2) qui vient juste de s'éteindre, est empêchée jusqu'à la diminution de la charge superficielle localement limitée.
